# EUROPEAN PATENT APPLICATION

(11) **EP 2 749 986 A2**
(43) Date of publication of application: **02.07.2014**
(21) Application number: 13157721.5
(22) Date of filing: 05.03.2013
(51) Int. Cl.: G06F 1/16

(54) **Electronic device**

(30) Priority: 27.12.2012 TW 101150647
(71) Applicant: Acer Incorporated, New Taipei City 221 (TW)
(72) Inventor: Chen, Hsien-Wei, New Taipei City 221 (TW); Ling, Cheng-Nan, New Taipei City 221 (TW); Huang, Yi-Ta, New Taipei City 221 (TW); Chen, Chun-I, New Taipei City 221 (TW)
(74) Representative: Becker Kurig Straus

(57) **Abstract**

An electronic device (100) including a display (110), at least one hinge (120) and a main frame (130) is provided. The display includes a casing (110a), where the casing has at least one first engaging portion (112). The hinge has a second engaging portion (122) and a pivot portion (124), where the second engaging portion is engaged with the first engaging portion. The main frame is pivoted to the pivot portion.

## Description

### CROSS-REFERENCE TO RELATED APPLICATION

This application claims the priority benefit of Taiwan application serial no. 101150647, filed on December 27, 2012. The entirety of the above-mentioned patent application is hereby incorporated by reference herein and made a part of this specification.

### BACKGROUND OF THE INVENTION

### 1. Field of the Invention

The present invention generally relates to an electronic device, in particular, to an electronic device having a display.

### 2. Description of Related Art

In the current era of information explosion, electronic products have become indispensable in everyday life, and as science and technology evolve continuously, innovative electronic products being light, thin, and small continue to emerge. Regarding the development and application of personal computers (PCs), desktop PCs come into being first. The desktop PCs are large, and are not portable, so that later, portable notebook PCs are developed.

Generally speaking, a notebook PC includes a main frame and a display, and the display is pivoted to the main frame through a hinge, so that the display may be unfolded or folded relative to the main frame. The hinge is usually assembled in a screw-locking manner, so that a casing of the display is required to provide a space for screw-locking of the hinge, thereby increasing the thickness of the display, which is contrary to the trend of the notebook PC of becoming thinner.

### SUMMARY OF THE INVENTION

Accordingly, the present invention is directed to an electronic device, a display of which is thin.

The present invention provides an electronic device, which includes a display, at least one hinge, and a main frame. The display includes a casing, and the casing includes at least one first engaging portion. The hinge includes a second engaging portion and a pivot portion, and the second engaging portion is engaged with the first engaging portion. The main frame is pivotally connected to the pivot portion.

In an embodiment of the present invention, the first engaging portion protrudes from an edge of the casing and includes an engaging hole, and the second engaging portion is engaged with the engaging hole.

In an embodiment of the present invention, the engaging hole is a square hole.

In an embodiment of the present invention, the first engaging portion is located in the casing and includes a positioning column. The second engaging portion includes a positioning hole. The positioning column is engaged with the positioning hole.

In an embodiment of the present invention, the hinge is bonded to the casing by glue.

In an embodiment of the present invention, the display further includes a display module. The display module is disposed in the casing, and a part of the hinge extends along a direction to be positioned between the casing and the display module, so as to be bonded to the casing.

In an embodiment of the present invention, a length of the hinge along the direction is greater than a quarter of a length of the casing along the direction.

In an embodiment of the present invention, the display further includes a light transmitting plate and a display module, and the casing includes a frame and a back cover. The frame includes a front surface, a rear surface, and an opening. The front surface is opposite to the rear surface, the opening runs from the front surface to the rear surface, the light transmitting plate is bonded to the front surface and covers the opening, and the display module is fixed on the light transmitting plate and located in the opening. The back cover is bonded to the rear surface and covers the opening, and the opening is located between the light transmitting plate and the back cover.

In an embodiment of the present invention, the display further includes an optical adhesive layer, and the optical adhesive layer is bonded between the light transmitting plate and the display module.

In view of the above, according to the present invention, the casing of the display has the first engaging portion, and the hinge has the second engaging portion, so that the casing and the hinge can be engaged with each other through the first engaging portion and the second engaging portion. The hinge is assembled at the casing of the display by engaging the second engaging portion to the first engaging portion, and is not assembled by screw-locking, so that the casing of the display is not required to provide a space for screw-locking, and the display is enabled to be thin, thereby complying with the trend of the electronic device of becoming thinner. Further, compared with assembly by screw-locking, which consumes more time and labor, in the present invention, the hinge and the casing are assembled by engaging, which reduces working hours for assembly and reduces the number of components, thereby achieving the effect of reducing costs of manufacturing and assembly.

In order to make the aforementioned features and advantages of the present invention more comprehensible, embodiments are described in detail below with the accompanying drawings.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.

FIG. 1 is a schematic view of an electronic device according to an embodiment of the present invention.

FIG. 2 is an exploded view of a first engaging portion and a second engaging portion of FIG. 1.

FIG. 3 is a sectional view of a display of FIG. 1 along a I-I line.

FIG. 4 is a partially enlarged view of a light transmitting plate and a display module of FIG. 3.

FIG. 5 is a schematic view of an electronic device according to another embodiment of the present invention.

FIG. 6 is a sectional view of a display of FIG. 5 along a II-II line.

### DESCRIPTION OF THE EMBODIMENTS

Reference will now be made in detail to the present embodiments of the invention, examples of which are illustrated in the accompanying drawings. Wherever possible, the same reference numbers are used in the drawings and the description to refer to the same or like parts.

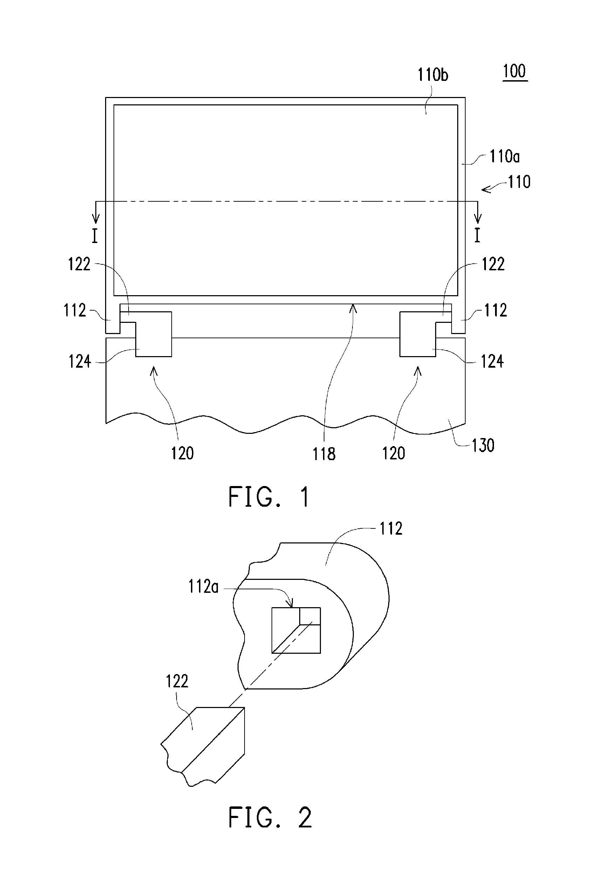

FIG. 1 is a schematic view of an electronic device according to an embodiment of the present invention. Referring to FIG. 1, an electronic device 100 of this embodiment is, for example, a notebook PC, and includes a display 110, at least one hinge 120 (two hinges 120 are shown), and a main frame 130. The display 110 includes a casing 110a, and the casing 110a has at least one first engaging portion 112 (two first engaging portions 112 are shown). Each hinge 120 has a second engaging portion 122 and a pivot portion 124. The two second engaging portions 122 are engaged with the two first engaging portions 112 respectively. The main frame 130 pivots around the pivot portion 124 of each hinge 120, so that the main frame 130 can be unfolded or folded relative to the display 110 through the hinges 120.

According to the aforementioned configuration manner, the hinge 120 is assembled at the casing 110a of the display 110 by engaging, and is not assembled by screw-locking, so that the casing 110a of the display 110 is not required to provide a space for screw-locking, and the display 110 is enabled to be thinner, thereby complying with the trend of the electronic device of becoming thinner. Further, compared with assembly by screw-locking, which consumes more time and labor, in this embodiment, the hinge 120 and the casing 110a are assembled by engaging, which reduces working hours for assembly and reduces the number of components, thereby achieving the effect of reducing costs of manufacturing and assembly.

FIG. 2 is an exploded view of the first engaging portion and the second engaging portion of FIG. 1. Referring to FIG. 1 and FIG. 2, the first engaging portion 112 of this embodiment protrudes from an edge 118 of the casing 110a, and has an engaging hole 112a; the second engaging portion 122 of the hinge 120 is a column, and is engaged with the engaging hole 112a of the first engaging portion 112. As shown in FIG. 2, in this embodiment, the engaging hole 112a of the first engaging portion 112 is, for example, a square hole, and the second engaging portion 122 of the hinge 120 is, for example, a square column, so as to be engaged with the square hole. In other embodiments, the engaging hole 112a and the second engaging portion 122 may be in other shapes, which is not limited by the present invention.

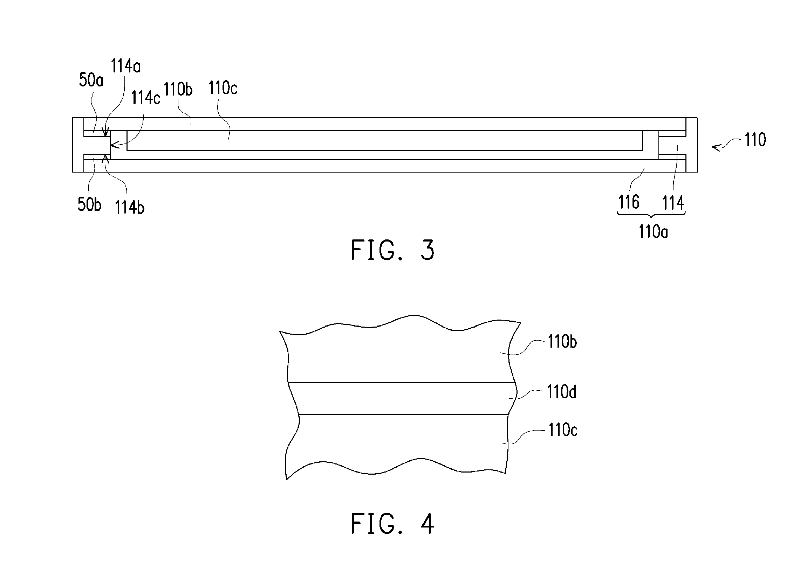

FIG. 3 is a sectional view of the display of FIG. 1 along I-I line. Referring to FIG. 3, the display 110 of this embodiment further includes a light transmitting plate 110b and a display module 110c, and the casing 110a includes a frame 114 and a back cover 116. The frame 114 has a front surface 114a, a rear surface 114b, and an opening 114c. The front surface 114a is opposite to the rear surface 114b. The opening 114c runs from the front surface 114a to the rear surface 114b. The light transmitting plate 110b is made of, for example, glass, and is bonded to the front surface 114a of the frame 114 through an adhesive layer 50a, and covers the opening 114c. The display module 110c is, for example, a liquid crystal display module (LCM), and is fixed on the light transmitting plate 110b and located in the opening 114c. The back cover 116 is bonded to the rear surface 114b of the frame 114 through an adhesive layer 140a, and covers the opening 114c. The opening 114c and the display module 110c in the opening 114c are located between the light transmitting plate 110b and the back cover 116.

In this embodiment, the display 110 is assembled by bonding the light transmitting plate 110b and the back cover 116 on the frame 114 , and screw-locking is not applied to assemble the light transmitting plate 110b, the frame 114, and the back cover 116, so that the frame 114 is not required to provide a space for screw-locking, thereby making the display 110 thin. Further, the frame 114 has the opening 114c located between the light transmitting plate 110b and the back cover 116, so that the display module 110c can be accommodated in the opening 114c, thereby further reducing the thickness of the display 110. Further, the back cover 116 is bonded to the frame 114, and is not connected to the frame 114 in an integrally formed manner, thereby facilitating replacement that uses the back cover 116 having a different color or pattern according to requirements on appearance.

FIG. 4 is a partially enlarged view of the light transmitting plate and the display module of FIG. 3. Referring to FIG. 4, in this embodiment, the display 110 further includes an optical adhesive layer 110d. The optical adhesive layer 110d is bonded between the light transmitting plate 110b and the display module 110c, so that the light transmitting plate 110b and the display module 110c are combined, and the light transmitting property of the optical adhesive layer 110d enables a user to view the display module 110c through the light transmitting plate 110b and the optical adhesive layer 110d.

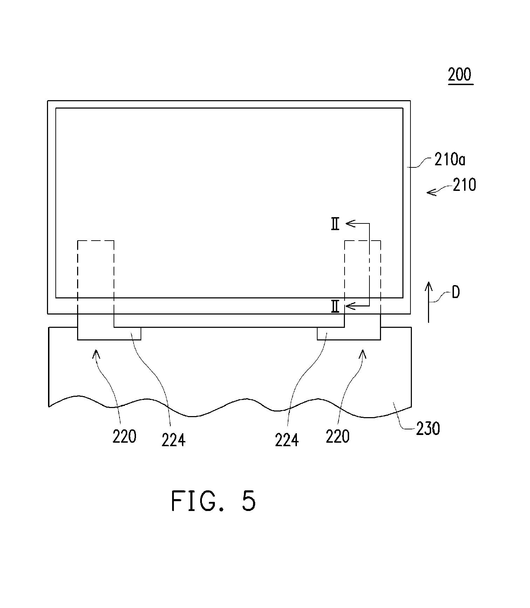

FIG. 5 is a schematic view of an electronic device according to another embodiment of the present invention. Referring to FIG. 5, similar to the electronic device 100 of FIG. 1, an electronic device 200 of this embodiment includes a display 210, at least one hinge 220 (two hinges 220 are shown), and a main frame 230. The display 210 includes a casing 210a. The hinge 220 is assembled at the display 210. A pivot portion 224 of the hinge 220 is pivotally connected to the main frame 230.

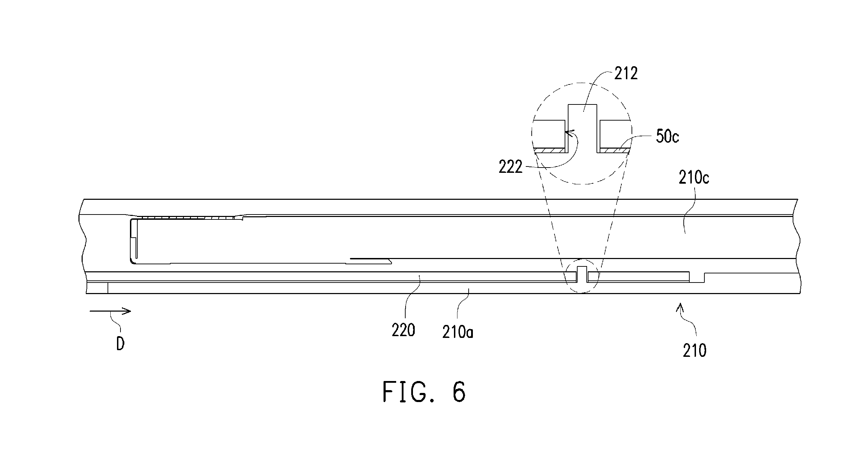

FIG. 6 is a sectional view of the display of FIG. 5 along II-II line. Referring to FIG. 5 and FIG. 6, differences between the electronic device 200 and the electronic device 100 are as follows. A first engaging portion 212 of the casing 210a is located in the casing 210a, and is a positioning column. A second engaging portion 222 of the hinge 220 is a positioning hole. The positioning column is engaged with the positioning hole. The hinge 220 is assembled at the casing 210a of the display 210 by engaging, and is not assembled by screw-locking, so that the casing 210a of the display 210 is not required to provide a space for screw-locking, and the display 210 is enabled to be thin, thereby complying with the trend of the electronic device of becoming thinner.

Compared with assembly by screw-locking, which consumes more time and labor, in this embodiment, the hinge 220 and the casing 210a are assembled by engaging, which reduces working hours for assembly and reduces the number of components, thereby achieving the effect of reducing costs of manufacturing and assembly. The present invention does not limit the number of the positioning column and the number of the positioning hole, which may be changed according to design requirements. Further, the present invention does not limit the form of the first engaging portion 212 and the form of the second engaging portion 222, and in other embodiments, the first engaging portion 212 and the second engaging portion 222 may be of other suitable structures capable of being engaged with each other.

In this embodiment, in addition to being assembled at the casing 210a by engaging, the hinge 220 is further combined with the casing 210a by bonding. Specifically, a display module 210c of the display 210 is disposed in the casing 210a, and a part of the hinge 220 extends along a direction D to be positioned between the casing 210a and the display module 210c, and is bonded to the casing 210a through an adhesive layer 50c. A part of the hinge 220 extends to be between the casing 210a and the display module 210c, which enables the hinge 220 to be longer, so that a larger bonding area is enabled to exist between the hinge 220 and the casing 210a, so as to firmly combine the hinge 220 with the casing 210a. For example, a length of the hinge 220 along the direction D is designed to be, for example, greater than a quarter of a length of the casing 210a along the direction D, so that the hinge 220 and the casing 210a have a sufficient bonding area. In other embodiments, the hinge 220 may have other extension length according to design requirements, which is not limited by the present invention.

In summary, according to the present invention, the casing of the display has the first engaging portion, and the hinge has the second engaging portion, so that the casing and the hinge can be engaged with each other through the first engaging portion and the second engaging portion. The hinge is assembled at the casing of the display by engaging, and is not assembled by screw-locking, so that the casing of the display is not required to provide a space for screw-locking, and the display is enabled to be thin, thereby complying with the trend of the electronic device of becoming thinner. Further, compared with assembly by screw-locking, which consumes more time and labor, in the present invention, the hinge and the casing are assembled by engaging, which reduces working hours for assembly and reduces the number of components, thereby achieving the effect of reducing costs of manufacturing and assembly. Further, in the display, the light transmitting plate and the back cover are assembled on the frame by bonding, so that the frame is not required to provide a space for screw-locking, thereby making the display thin. In addition, the display module can be accommodated in the opening of the frame, thereby further reducing the thickness of the display. Further, the back cover is bonded to the frame, and is not connected to the frame in an integrally formed manner, so as to enable replacement that uses the back cover having a different color or pattern according to requirements on appearance, thereby improving changeability of the appearance of the electronic device.

## Claims

1. An electronic device (100, 200), comprising:
a display (110, 210), comprising a casing (110a, 210a), wherein the casing (110a, 210a) comprises at least one first engaging portion (112, 212);
at least one hinge (120, 220), comprising a second engaging portion (122, 222) and a pivot portion (124, 224), wherein the second engaging portion (122, 222) is engaged with the first engaging portion (112, 212); and
a main frame (130, 230), pivotally connected to the pivot portion (124, 224).

2. The electronic device (100) according to claim 1, wherein the first engaging portion (112) protrudes from an edge (118) of the casing (110a) and comprises an engaging hole (112a), and the second engaging portion (122) is engaged with the engaging hole (112a).

3. The electronic device (100) according to claim 2, wherein the engaging hole (112a) is a square hole.

4. The electronic device (200) according to claim 1, wherein the first engaging portion (212) is located in the casing (210a) and comprises a positioning column, the second engaging portion (222) comprises a positioning hole, and the positioning column is engaged with the positioning hole.

5. The electronic device (200) according to claim 1, wherein the hinge (220) is bonded to the casing (210a).

6. The electronic device (200) according to claim 5, wherein the display (210) further comprises a display module (210c), the display module (210c) is disposed in the casing (210a), and a part of the hinge (220) extends along a direction (D) to be positioned between the casing (210a) and the display module (210c), so as to be bonded to the casing (210a).

7. The electronic device (200) according to claim 6, wherein a length of the hinge (220) along the direction (D) is greater than a quarter of a length of the casing (210a) along the direction (D).

8. The electronic device (100) according to claim 1, wherein the display (110) further comprises a light transmitting plate (110b) and a display module (110c), and the casing (110a) comprises:
a frame (114), comprising a front surface (114a), a rear surface (114b), and an opening (114c), wherein the front surface (114a) is opposite to the rear surface (114b), the opening (114c) runs from the front surface (114a) to the rear surface (114b), the light transmitting plate (110b) is bonded to the front surface (114a) and covers the opening (114c), and the display module (110c) is fixed on the light transmitting plate (110b) and located in the opening (114c); and
a back cover (116), bonded to the rear surface (114b) and covering the opening (114c), wherein the opening (114c) is located between the light transmitting plate (110b) and the back cover (116).

9. The electronic device (100) according to claim 8, wherein the display (110) further comprises an optical adhesive layer (110d), and the optical adhesive layer (110d) is bonded between the light transmitting plate (110b) and the display module (110c).
